(19) Europäisches Patentamt
European Patent Office
Office européen des brevets

(11) Numéro de publication: **0 070 746**
**A1**

(12) **DEMANDE DE BREVET EUROPEEN**

(21) Numéro de dépôt: **82400993.0**

(22) Date de dépôt: **28.05.82**

(51) Int. Cl.³: **C 09 D 3/82**, C 08 L 83/06, C 08 L 83/08, G 03 F 7/10

(30) Priorité: **15.06.81 FR 8111706**

(43) Date de publication de la demande: **26.01.83 Bulletin 83/4**

(84) Etats contractants désignés: **DE NL SE**

(71) Demandeur: **RHONE-POULENC SPECIALITES CHIMIQUES, "Les Miroirs" 18, Avenue d'Alsace, F-92400 Courbevoie (FR)**

(72) Inventeur: **Pigeon, Raymond, 52, Chemin Moulin du Got, F-69340 Francheville (FR)**

(74) Mandataire: **Fichet, Edouard et al, RHONE POULENC RECHERCHES Service Brevets Chimie et Polymères 25, quai Paul Doumer, F-92408 Courbevoie Cedex (FR)**

(54) **Compositions organopolysiloxaniques liquides photopolymérisables pour enduction de matériaux.**

(57) Compositions organopolysiloxaniques liquides photopolymérisables.

Ces compositions sont caractérisées en ce qu'elles sont formées par mélange d'un composé organosilicique comportant au moins un radical phényle et un radical $CH_2 = C(R)COQ$ – dans lequel R représente un atome d'hydrogène ou le radical méthyle et Q représente les radicaux –O– et –NH–, d'un organohydrogénopolysiloxane portant liés à ses atomes de silicium au moins un radical phényle et au moins un atome d'hydrogène, le rapport des quantités de ces deux composés étant tel que le rapport molaire des groupes $CH_2 = CRCOQ$ du premier composé aux groupes SiH du deuxième composé s'étale de 0,5 à 7, et d'un photosensibilisateur choisi parmi les dérivés de la benzoïne, de la xanthone ou de la tioxanthone.

Ces compostiions après imprégnation de matériaux puis photopolymérisation, conduisent à des revêtement d'excellente adhérence.

EP 0 070 746 A1

# COMPOSITIONS ORGANOPOLYSILOXANIQUES LIQUIDES PHOTOPOLYMERISABLES POUR ENDUCTION DE MATERIAUX

La présente invention a pour objet des compositions organopolysiloxaniques liquides, photopolymérisables par les radiations ultra-violettes, portant des radicaux organiques renfermant des groupes à insaturation aliphatique choisis parmi les groupes acryloyloxyles, méthacryloyloxyles, acrylamido, méthacrylamido, durcissant en revêtements ayant de bonnes propriétés mécaniques et une adhérence améliorée vis-à-vis des matériaux solides les plus divers.

Des compositions organopolysiloxaniques liquides, portant des radicaux organiques renfermant des groupes à insaturation aliphatique, durcissant par exposition aux radiations ultra-violettes, ont déjà été décrites et utilisées. Certaines, parmi ces compositions, peuvent servir à la préparation de revêtements antiadhérents à l'égard des matières visqueuses et collantes. De telles compositions sont constituées, par exemple :

- de polymères organopolysiloxaniques de degré de polymérisation supérieur à 25, portant chacun au moins un radical organique renfermant un groupe acryloyloxyle ou méthacryloyloxyle, ce radical état lié à un atome de silicium par l'intermédiaire d'une liaison C-Si ou C-O-Si
- (1) de di, tri ou tétraesters acryliques ou méthacryliques de polyols, ou (2) de composés organosiliciques de faible masse moléculaire, ayant de 1 à 25 atomes de silicium, refermant de 2 à 6 groupes acryloyloxyles ou méthacryloyloxyles
- de photosensibilisateurs

(demande européenne publiée n° 6705).

Elles sont encore constituées :

- de polymères organopolysiloxaniques formés de 0,5 à 100 moles % de motifs organosiloxyles portant chacun un groupe vinyle ; les autres motifs organosiloxyles présents portant des radicaux hydrocarbonés, halogénés ou non, dépourvus d'insaturation aliphatique
- de polymères organohydrogénopolysiloxaniques portant chacun au moins un atome d'hydrogène lié à un atome de silicium

le rapport des groupes Si-vinyles des polymères organopolysiloxaniques aux groupes SiH des polymères organohydrogénopolysiloxaniques étant compris dans l'intervalle 1/100 à 100/1.

- de photosensibilisateurs
- éventuellement de composés organosiliciques à fonctions mercapto comme accélérateurs de durcissement (demandes françaises 2 245 729 et 2 257 736).

D'autres, parmi ces compositions, peuvent servir à la préparation de revêtements dont les caractéristiques physiques sont axées plus particulièrement vers la solidité, la résistance aux solvants, l'adhérence aux supports. Ces compositions sont assez proches de celles citées précédemment. Ainsi elles sont constituées par exemples :

- de polymères organopolysiloxaniques renfermant des groupes acryloyloxyles ou méthacryloyloxyles liés aux atomes de silicium par l'intermédiaire de radicaux hydrocarbonés divalents
- de photosensibilisateurs
- de solvants

(demande française 2 110 115).

Elles sont constituées encore :

- de polymères organopolysiloxaniques renfermant des groupes acryloyloxyles ou méthacryloyloxyles liés aux atomes de silicium par l'intermédiaire de radicaux organiques divalents formés d'atomes de carbone, d'hydrogène, d'azote et d'oxygène
- de photosensibilisateurs

(demande japonaise publiée avant examen 54 038 393, demande allemande 3 006 167).

Les revêtements, issus des compositions ci-dessus, sont destinés à protéger des matériaux placés dans un environnement agressif. Toutefois lorsque ces matériaux sont soumis à de nombreux chocs mécaniques et/ou thermiques, à des emboutissages profonds, à l'action prolongée de solvants ou des intempéries, les revêtements déposés ne conservent pas d'une façon durable leur pouvoir protecteur. Il en résulte que les matériaux utilisés dans de telles conditions perturbent sérieusement ou même arrêtent (en particulier dans le domaine des circuits électroniques) le fonctionnement d'appareillages dans lesquels ils sont introduits. Il est donc nécessaire de chercher à améliorer les propriétés de ces revêtements.

Dans ce dessein la présente invention propose de nouvelles compositions organopolysiloxaniques liquides, photopolymérisables, qui conduisent à des revêtements possédant d'excellentes propriétés mécaniques et en outre une très forte adhérence à l'égard des matériaux (d'une nature quelconque) sur lesquels ils sont déposés. Ces matériaux enduits peuvent être employés dans des domaines aussi variés que ceux de l'électronique, de l'électrotechnique, du bâtiment, de la métallurgie, du traitement du papier, du carton, des textiles, du bois.

Plus précisément la présente invention se rapporte à des compositions organopolysiloxaniques liquides, de viscosité allant de 100 mPa.s à 25°C à 10 000 mPa.s à 25°C, photopolymérisables , formées par mélange de :

A/ au moins un radical organosilicique, monomère ou polymère, portant liés à son ou ses atomes de silicium

1) au moins un radical organique renfermant un groupe non saturé de formule $CH_2 = C(R)COQ-$ dans laquelle le symbole R représente un atome d'hydrogène, le radical méthyle, et le symbole Q représente O, NH,

2) au moins un radical phényle

les autres radicaux organiques étant choisis dans le groupe constitué des radicaux méthyles, éthyles, propyles, trifluoro-3,3,3 propyles, vinyles, alcoxyles ayant de 1 à 5 atomes de carbone, β-methoxyethoxyles, hydroxyles.

B/ au moins un organohydrogénopolysiloxane portant liés à ses atomes de silicium au moins un atome d'hydrogène et au moins un radical phényle, les autres radicaux étant des radicaux méthyles

les composés A et B étant employés en quantités suffisantes pour conduire à un rapport molaire des groupes SiH, apportés par l'organohydrogénopolysiloxane B, aux groupes $CH_2$=CRCOQ-, apportés par le composé A, s'étalant de 0,5 à 7.

C/ un photosensibilisateur choisi parmi les dérivés de la benzoïne, de la xanthone ou de la thioxanthone, à raison de 0,1 à 10 parties pour 100 parties de l'ensemble des composés A et B

D/ un diluant organique, inerte vis-à-vis des composés A, B et C, à raison de 0 à 150 parties pour 100 parties de l'ensemble des composés A et B.

Le composé organosilicique A peut posséder un nombre quelconque d'atomes de silicium et avoir une structure également quelconque, linéaire, ramifiée, réticulée, cyclique. Il peut être choisi parmi des silanes, des polysilanes, des organopolysiloxanes huileux, gommeux, résineux, des polymères organosiliciques renfermant des enchaînements Si-T-Si et Si-O-Si (le symbole T représentant un radical organique divalent), des polymères mixtes organiques-organopolysiloxaniques formés, par exemple, par réaction d'organopolysiloxanes portant des groupes hydrolysables avec des polymères organiques (en particulier, polyesters, polyéthers, polyepoxydes, polyamides, polyuréthannes, polyamines, polycarbonates, polyoléfines) portant des groupes pouvant réagir avec les groupes hydrolysables.

Toutefois, de préférence, le composé A est choisi parmi les silanes de formules générales :

$$\left[CH_2{=}C(R)COQG(O)_a\right]_b SiR'_c R''_{4-b-c} \qquad F_1$$

$$\left[CH_2{=}C(R)COQCH_2\right]_{b'} G'OSiR'_c R''_{3-c} \qquad F_2$$

dans lesquelles

- les symboles R et Q ont la signification précédente,
- le symbole G représente des radicaux alcoylènes divalents, linéaires ou ramifiés, ayant de 1 à 5 atomes de carbone,
- le symbole G' représente des radicaux alcoylènes tri ou tétravalents, linéaires ou ramifiés, ayant de 1 à 5 atomes de carbone,
- le symbole R' représente un radical méthyle, éthyle, propyle, phényle, vinyle, trifluoro-3,3,3 propyle,
- le symbole R" représente un radical alcoxyle ayant de 1 à 5 atomes de carbone, un radical β-methoxyethoxyle,
- le symbole a représente zéro ou 1,
- le symbole b représente 1, 2 ou 3 quand a = 1 ; il représente seulement 1 quand a = zéro,
- le symbole c représente 1, 2 ou 3
- le symbole b' représente 2 ou 3

au moins un radical R' représente un radical phényle.

A titre illustratif de radicaux alcoylènes divalents, ayant de 1 à 5 atomes de carbone, représentés par le symbole G, peuvent être

cités ceux de formules :

$$-CH_2- \;,\; -(CH_2)_2- \;,\; -(CH_2)_3- \;,\; -CH_2CH(CH_3)- \;,\; -(CH_2)_4- \;,$$
$$-CH_2-CH(CH_3)CH_2CH_2-$$

A titre illustratif de radicaux alcoylènes tri ou tétravalents, ayant de 1 à 5 atomes de carbone, représentés par le symbole G', peuvent être cités ceux de formules :

$$=CH- \;,\; \equiv C-CH_2- \;,\; =C(CH_3)CH_2- \;,\; =C(CH_2CH_3)CH_2-$$

A titre illustratif de radicaux alcoxyles, ayant de 1 à 5 atomes de carbone, représentés par le symbole R", peuvent être cités les radicaux methoxyles, ethoxyles, n-propoxyles, isopropoxyles, n-butoxyles, sec-butoxyles, n-pentoxyles.

Ces silanes sont souvent disponibles sur le marché des produits chimiques et peuvent être aisément fabriqués selon des techniques connues. Ainsi les silanes de formules :

$$\left[CH_2=C(R)COQGO\right]_b\ SiR'_cR''_{4-b-c} \qquad F'_1$$

(dérivant de la formule $F_1$ dans laquelle a = 1 et b = 1, 2 ou 3) peuvent être préparés par réaction des composés hydroxylés, insaturés, de formule $CH_2=C(R)COQGOH$ avec des silanes de formule $Cl_bSiR'_cR''_{4-b-c}$, l'acide HCl étant éliminé au cours de la réaction.

Les silanes de formule :

$$CH_2=C(R)COQGSiR'_cR''_{3-c} \qquad F''_1$$

(dérivant de la formule $F_1$ dans laquelle a = 0 et b = 1) peuvent être préparés par réaction des composés insaturés de formule $CH_2=C(R)COQH$ ou de formule $CH_2=C(R)COQMe$ (Me = métal alcalin) avec les silanes de formule $XGSiR'_cR''_{3-c}$ (X = Br, Cl), l'acide XH, ou le sel XMe, étant éliminé au cours de la réaction.

Les silanes de formule $F_2$ peuvent être préparés par réaction des composés hydroxylés de formule :

$\left[CH_2{=}C(R)COQCH_2\right]_{b'}G'OH$ avec les silanes de formule $ClSiR'_cR''_{3-c}$ ou de formule $HSiR'_cR''_{3-c}$, l'acide HCl, ou de l'hydrogène, étant éliminé au cours de la réaction ; dans le cas du dégagement d'hydrogène, la réaction est facilitée par la présence d'un catalyseur (amine, dérivé métallique, sel carboxylique d'étain).

A titre d'exemples concrets de silanes, représentés par les formules $F'_1$, $F''_1$ et $F_2$, peuvent être cités ceux répondant aux formules suivantes :

$F'_1$ :

$$CH_2{=}C(CH_3)COOCH_2CH_2OSi(C_6H_5)_2CH_3$$
$$\left[CH_2{=}C(CH_3)COOCH_2CH_2O\right]_2Si(C_6H_5)_2$$
$$\left[CH_2{=}CH{-}COOCH_2CH_2O\right]_2Si(C_6H_5)_2$$
$$\left[CH_2{=}CHCOOCH_2CH(CH_3)O\right]_2Si(C_6H_5)(CH_3)$$
$$CH_2{=}CHCONHCH_2O{-}SiC_6H_5(CH_3)_2$$
$$\left[CH_2{=}C(CH_3)COOCH_2CH_2O\right]_3SiC_6H_5$$

$F''_1$ :

$$CH_2{=}C(CH_3)COO(CH_2)_3Si(C_6H_5)_2CH_3$$
$$CH_2{=}CHCOO(CH_2)_3Si(C_6H_5)_2(O{-}nC_4H_9)$$
$$CH_2{=}C(CH_3)CONH(CH_2)_3SiC_6H_5(OCH_3)_2$$

$F_2$ :

$$\left[CH_2{=}C(CH_3)COOCH_2\right]_3C{-}CH_2OSi(C_6H_5)(CH_3)_2$$
$$(CH_2{=}CH{-}COOCH_2)_2CHOSi(C_6H_5)_2CH_3$$
$$\left[CH_2{=}C(CH_3)COOCH_2\right]_2C(CH_2CH_3)CH_2OSi(C_6H_5)_2(O{-}nC_3H_7)$$

De préférence le composé A est encore choisi parmi les polymères organopolysiloxaniques, linéaires ou ramifiés, liquides, de viscosité au plus 30 000 mPa.s à 25°C, ou solides de point de fusion inférieur à 120°C. Ces polymères peuvent se diviser en 2 classes. La première classe comporte des polymères de structure généralement bien définie, ne renfermant pratiquement pas de radicaux alcoxyles et/ou hydroxyles liés aux atomes de silicium.

Ils sont constitués

- de 1 à 100 moles % de motifs choisis parmi ceux de formules :

$$CH_2{=}C(R)COQG(O)_aSiR'_dO_{\frac{3-d}{2}}$$

$$\left[CH_2{=}C(R)COQCH_2\right]_{b'}G'OSiR'_dO_{\frac{3-d}{2}}$$

dans lesquelles les symboles R, Q, R', G, G', a et b' ont la même signification que celle donnée précédemment pour les silanes de formules $F_1$ et $F_2$, et le symbole d représente 1 ou 2

- de 99 à 0 moles % de motifs de formule $R'_fSiO_{\frac{4-f}{2}}$

dans laquelle le symbole R' a la signification précédente, le symbole f représente 1, 2 ou 3 :

- le rapport molaire (R' + Z)/Si, s'étend de 1,4 à 3,
- le symbole Z représentant les radicaux de formules générales :

$$CH_2{=}C(R)COQG(O)_{\overline{a}}$$
$$(CH_2{=}C(R)COQCH_2)_{b'}G'O-$$

en outre, 5 moles % de radicaux R', de préférence 10 moles %, sont des radicaux phényles.

La préparation de ces polymères est aisée ; elle peut être effectuée, par exemple, en partant d'organopolysiloxanes rentrant dans les définitions précédentes mais contenant à la place des motifs de formule :

$$CH_2{=}C(R)COQG(O)_aSiR'_dO_{\frac{3-d}{2}}$$

ou de formule

$$\left[CH_2{=}C(R)COQCH_2\right]_{b'}G'OSiR'_dO_{\frac{3-d}{2}}$$

des motifs de formule $HSiR'_dO_{\frac{3-d}{2}}$.

Ces organopolysiloxanes sont alors mis en contact avec les composés organiques hydroxylés insaturés (utilisés précédemment pour la préparation des silanes de formule $F'_1$ et $F_2$) de formule $CH_2{=}C(R)COQGOH$ ou de formule $\left[CH_2{=}C(R)COQCH_2\right]_{b'}G'OH$, en présence d'un catalyseur approprié tel qu'un sel carboxylique d'étain, de la N, N-diéthylhydroxylamine. Il y a formation d'hydrogène selon le

schéma E O H + H Si $\longrightarrow H_2$ + E O Si, le symbole E représentant les radicaux de formules générales

$$CH_2=C(R)COQG- \quad \text{et} \quad \left[CH_2=C(R)COQCH_2\right]_{b'}G'-$$

et obtention des enchaînements désirés de formule $CH_2=C(R)COQGOSi-$ (dérivant de la formule $CH_2=C(R)COQG(O)_aSi-$ dans laquelle le symbole a représente 1) et de formule $\left[CH_2= C(R)COQCH_2\right]_{b'}G'OSi-$.

Cette préparation peut encore être réalisée en partant d'organopolysiloxanes semblables aux précédents sauf qu'ils possèdent à la place des motifs de formule

$$HSiR'_dO_{\frac{3-d}{2}} \text{, des motifs de formule } ClSiR'_dO_{\frac{3-d}{2}}.$$

Il n'y a plus formation d'hydrogène mais d'HCl selon le schéma E O H + ClSi $\longrightarrow$ HCl + EOSi (E ayant la signification précédente), et la présence d'un catalyseur n'est plus nécessaire.

Elle peut aussi être effectuée en partant toujours d'un même type d'organopolysiloxanes sauf que ceux-ci possèdent à la place des motifs de formule

$$HSiR'_dO_{\frac{3-d}{2}} \text{, ou } ClSiR'_dO_{\frac{3-d}{2}},$$

des motifs de formule $XGSiR'_dO_{\frac{3-d}{2}}$ (X = Cl, Br).

Ces organopolysiloxanes sont alors mis en contact avec des composés organiques insaturés (utilisés précédemment pour la synthèse des silanes de formule $F''_1$) de formule $CH_2=C(R)COQH$ ou $CH_2=C(R)COQMe$ (Me = métal alcalin) ; il y a formation d'acide XH ou de sel XMe et obtention de l'enchaînement recherché de formule $CH_2=C(R)COQGSi-$ dérivant de la formule $CH_2=C(R)COQG(O)_aSi$ dans laquelle le symbole a représente zéro.

A titre d'exemples concrets de ces polymères organopolysiloxaniques peuvent être cités ceux de formules :

$$\left[CH_2=C(CH_3)COOCH_2CH(CH_3)OSiCH_3(C_6H_5)\right]_2O$$

$$\left[CH_2=C(CH_3)COOCH_2CH_2OSi(CH_3)_2O\right]_2Si(C_6H_5)_2$$

$$(CH_3)_2C_6H_5Si\left[OSi(CH_3)_2\right]_{10}\left[\begin{matrix}OSi(CH_3)\\ |\\ OCH_2CH_2NHCOCH{=}CH_2\end{matrix}\right]_5 OSiC_6H_5(CH_3)_2$$

un copolymère constitué de :

- 5 moles % de motifs de formule $CH_2{=}C(CH_3)COO(CH_2)_3Si(CH_3)O$
- 3 moles % de motifs de formule $(CH_3)_3SiO_{0,5}$
- 17 moles % de motifs de formule $(CH_3)(C_6H_5)SiO$
- 45 moles % de motifs de formule $CH_3SiO_{1,5}$
- 30 moles % de motifs de formule $(CH_3)_2SiO$

La deuxième classe comporte des polymères renfermant une certaine proportion de radicaux alcoxyles et/ou hydroxyles liés aux atomes de silicium ; ces polymères sont assez proches des polymères précédents, cependant leur structure est moins nettement déterminée. Ils sont plus aisément définis par leur procédé de préparation.

Ce procédé est caractérisé en ce que

(1) l'on met en contact

- soit des organopolysiloxanes formés de motifs de formule

$$R'_fSiO_{\frac{4-f}{2}}$$

dans laquelle les symboles R' et f ont la même signification que celle donnée précédemment pour la description des motifs des polymères de la première classe, ayant un rapport molaire R'/Si allant de 1,1 à 2,1 et contenant de 2 à 10 % de radicaux hydroxyles liés aux atomes de silicium, au moins 5 moles % des radicaux R' étant des radicaux phényles, avec des silanes choisis parmi ceux de formules :

$$CH_2{=}C(R)COQG(O)_aSiR'_eR'''_{4-e} \qquad F_3$$

$$\left[CH_2{=}C(R)COQCH_2\right]_{b'}G'OSiR'_eR'''_{3-e} \qquad F_4$$

dans lesquelles les symboles R, Q, G, G', R', a et b' ont la même signification que celle donnée pour la description des silanes de formules $F_1$ et $F_2$, le symbole R''' représente un radical methoxyle, ethoxyle, et le symbole e représente zéro ou 1 ; les organopolysiloxanes et les silanes sont employés en quantité suffisante pour conduire à un rapport molaire des radicaux hydroxyles apportés par les organopolysiloxanes, aux radicaux methoxyles et/ou ethoxyles

apportés par les silanes, s'étalant de 0,7 à 1,3.

- soit des organopolysiloxanes formés des mêmes motifs de formule

$$R'_{f}SiO_{\frac{4-f}{2}}$$

dans laquelle les symboles R' et f ont la même signification que celle donnée précédemment, ayant le même rapport molaire R'/Si allant de 1,1 à 2,1 mais contenant de 5 à 17 % de groupes methoxyles et/ou ethoxyles, au moins 5 moles % des radicaux R' étant des radicaux phényles, avec des composés organiques hydroxylés insaturés, déjà utilisés pour la préparation des silanes de formules $F'_1$ et $F_2$, de formule $CH_2=C(R)COQGOH$ ou de formule $(CH_2=C(R)COQCH_2)_{b'}G'OH$ (les symboles R, Q, G, G', b' ont donc la même signification que celle donnée pour la description des silanes de formules $F_1$ et $F_2$) ; les organopolysiloxanes et les silanes sont employés en quantité suffisante pour conduire à un rapport molaire des radicaux hydroxyles apportés par les composés organiques insaturés, aux radicaux methoxyles et/ou ethoxyles apportés par les organopolysiloxanes, s'étalant de 0,7 à 1,3.

(2) puis porte l'ensemble, en présence d'un catalyseur, dans un domaine de températures allant de 15 à 170°C, pendant une durée suffisante pour éliminer au plus 75 % de la quantité théorique de l'alcool attendu (méthanol et/ou éthanol).

Pour opérer selon ce procédé on mélange les organopolysiloxanes et les silanes dans des proportions qui permettent de fournir un rapport molaire radicaux hydroxyles/radicaux methoxyles et/ou ethoxyles allant de 0,7 à 1,3, de préférence de 0,75 à 1,25. On ajoute un catalyseur à raison de 0,05 à 1 % de l'ensemble des réactifs. Ce catalyseur peut être choisi parmi les titanates et polytitanates d'alcoyles et les sels de diorganoétains d'acides carboxyliques. De préférence, on utilise les titanates d'alcoyles tels que le titanate d'isopropyle, d'éthyle, de n-butyle.

Pour faciliter le mélange des réactifs, des diluants inertes peuvent être employés, choisis par exemple parmi les hydrocarbures aliphatiques, cycloaliphatiques, aromatiques, halogénés ou non.

A titre illustratif de diluants de ce type peuvent être cités le n-heptane, le cyclohexane, le méthylcyclohexane, le toluène, le xylène, le perchloroéthylène, le chlorobenzène, les diverses coupes

pétrolières.

La quantité introduite peut être quelconque ; il est toutefois préférable d'en introduire la quantité juste nécessaire à l'obtention du résultat recherché, quantité qui représente souvent de 5 à 50 % des réactifs. Les mélanges comprenant les organopolysiloxanes et les silanes, le catalyseur et éventuellement les diluants sont alors chauffés dans un domaine de températures allant de 15 à 170°C, de préférence ne dépassant pas 150°C. Au cours de ce chauffage, du méthanol ou de l'éthanol (ou le mélange des deux) est éliminé à raison d'au plus 75 % de la quantité théorique attendue, de préférence d'au plus 70 %. Les diluants éventuels peuvent aussi être éliminés par distillation ou conservés (partiellement ou en totalité) ; dans ce dernier cas, ils serviront ultérieurement à diminuer la viscosité des compositions photopolymérisables conformes à l'invention.

A titre d'exemples concrets, les organopolysiloxanes renfermant des groupes hydroxyles ou alcoxyles peuvent être plus spécialement formés de motifs choisis parmi ceux de formules :

$(C_6H_5)_2SiO$ , $C_6H_5SiO_{1,5}$ , $C_6H_5(CH_3)SiO$ , $(C_6H_5)(CH_3)_2SiO_{0,5}$

$(C_6H_5)_2CH_3SiO_{0,5}$ , $(CH_3)_2SiO$ , $(CH_3)SiO_{1,5}$ , $(CH_3)(CH_2{=}CH)SiO$

$(CH_3)_2(CH_2{=}CH)SiO_{0,5}$ , $(CH_3)_3SiO_{0,5}$ .

Ces motifs, et les autres englobés dans la formule

$$R'_fSiO_{\frac{4-f}{2}}$$

sont évidemment distribués de manière à obtenir un rapport molaire R'/Si allant de 1,1 à 2,1, de préférence de 1,2 à 2 ; par ailleurs, au moins 5 moles % de radicaux R', de préférence au moins 10 moles % de ces radicaux sont des radicaux phényles.

Les organopolysiloxanes contenant des groupes hydroxyles peuvent être préparés selon les méthodes classiques d'hydrolyse des chlorosilanes ; ceux-ci peuvent être mis en contact avec de l'eau ou des mélanges eau + diluants (les diluants étant miscibles et/ou non miscibles avec l'eau). De telles méthodes figurent en particulier dans le brevet français 1 581 964, le brevet américain 3 120 500, la

demande allemande 2 415 331.

Les organopolysiloxanes contenant des goupes alcoxyles peuvent être préparés, également selon les méthodes classiques d'hydrolyse des chlorosilanes à condition toutefois que dans le milieu d'hydrolyse figure du méthanol et/ou de l'éthanol (brevet américain 2 810 704).

Ces organopolysiloxanes peuvent encore être préparés par hydrolyse d'alcoxysilanes, de chloroalcoxysilanes ou de mélanges d'alcoxysilanes et de chlorosilanes. Des procédés de ce type figurent en particulier dans les brevets américains 3 450 672, 3 668 180, 3 826 773.

En opérant selon ces 2 méthodes d'hydrolyse les organopolysiloxanes obtenus peuvent parfois contenir en dehors des radicaux methoxyles et ethoxyles une petite quantité, au plus 2 %, de radicaux hydroxyles. Ils peuvent en outre être préparés par une autre voie : la réaction de chlorosilanes avec un mélange de méthanol ou d'éthanol et d'un alcool aliphatique tertiaire (demande française 2 086 349).

Les silanes mis en contact avec les organopolysiloxanes à groupes hydroxyles répondent aux formules précitées $F_3$ et $F_4$. Ces silanes sont disponibles sur le marché des produits chimiques ; en outre comme ils sont très proches des silanes de formules $F_1$ et $F_2$ ils peuvent être préparés selon les mêmes techniques.

A titre d'exemples concrets de ces silanes peuvent être cités ceux de formules :

$$CH_2=C(CH_3)COO-CH_2CH_2OSi(OC_2H_5)_3$$
$$CH_2=C(CH_3)COO(CH_2)_3Si(OCH_3)_3$$
$$(CH_2=CH-COOCH_2)_3C-CH_2OSi(OC_2H_5)_3$$

Une fraction des composés organosiliciques A monomères et/ou polymères, peut être remplacée par des produits liquides $A_1$, organiques et/ou organosiliciques, portant également des groupes à insaturation aliphatique. Cette fraction fournit au plus 75 moles % des groupes à insaturation aliphatique mis en oeuvre dans les compositions conformes à l'invention.

Ces produits $A_1$, miscibles en toutes proportions avec les composés A, sont choisis dans le groupes constitué :

- des dérivés du bisphénol A de formule

$[CH_2=C(R)COO-CH_2CH_2OC_6H_4]_2C(CH_3)_2$ dans laquelle le symbole R représente un atome d'hydrogène, un radical méthyle

- des polymères organopolysiloxaniques formés de 2 à 60 moles % de motifs de formule

$$CH_2=CH(R_1)_gSiO_{\frac{3-g}{2}}$$

et de 98 à 40 moles % de motifs de formule

$$(R_1)_{g'}SiO_{\frac{4-g'}{2}}$$

dans lesquelles formules le symbole $R_1$ représente un radical méthyle, phényle, le symbole g représente zéro, 1 ou 2, le symbole g' représente 1,2 ou 3, le rapport molaire ($R_1$ + $CH_2$=CH)/Si s'étend de 1,4 à 2,3, au moins 5 moles % des radicaux $R_1$ sont des radicaux phényles.

Les dérivés du bisphénol A comportent les composés de formules :

$$[CH_2=C(CH_3)COO-CH_2CH_2O-C_6H_4]_2C(CH_3)_2$$
$$[CH_2=CH-COO-CH_2CH_2OC_6H_4]_2C(CH_3)_2$$

qui présentent des viscosités de l'ordre de 2 000 mPa.s à 25°C.

Les polymères organopolysiloxaniques $A_1$ sont formés de motifs plus spécialement choisis dans le groupe constitué de ceux de formules :

$CH_3SiO_{1,5}$ , $(CH_3)_2SiO$ , $(CH_3)_3SiO_{0,5}$ , $CH_2=CHSiO_{1,5}$ , $CH_2=CH(CH_3)SiO$ , $CH_2=CH(CH_3)_2SiO_{0,5}$ , $CH_2=CH(CH_3)C_6H_5SiO_{0,5}$ , $(C_6H_5)SiO_{1,5}$ , $(C_6H_5)_2$ SiO , $C_6H_5(CH_3)SiO$ , $C_6H_5(CH_3)_2$ $SiO_{0,5}$ , $(C_6H_5)_2CH_3SiO_{0,5}$ .

Ces motifs sont répartis de manière à satisfaire aux exigences précitées, en particulier obtenir

- un rapport molaire ($R_1$ + $CH_2$=CH)/Si s'étendant de 1,4 à 2,3, de préférence de 1,5 à 2,2
- qu'au moins 5 moles %, de préférence 10 moles %, des radicaux $R_1$ soient des radicaux phényles.

Les dérivés du bisphénol A sont disponibles sur le marché des produits chimiques ; il en est de même des produits organosiliciques $A_1$. En outre, ces derniers peuvent être aisément préparés par des techniques d'hydrolyse déjà décrites. Une de ces techniques consiste par exemple :

- à hydrolyser des chlorosilanes choisis parmi ceux conduisant aux motifs illustrés ci-avant
- à traiter les hydrolysats à chaud en présence d'un catalyseur permettant le réarrangement des liaisons siloxanes et la condensation des radicaux Si-OH (brevet français 1 568 812).

L'organohydrogénopolysiloxane B porte, liés à l'ensemble de ses atomes de silicium, au moins un atome d'hydrogène et au moins un radical phényle, les autres radicaux étant des radicaux méthyles. Ce polymère peut avoir un degré quelconque de polymérisation et se présenter sous la forme d'une huile, d'une gomme ou d'une résine. Toutefois, de préférence, l'organohydrogénopolysiloxane B est une huile de viscosité au plus 100 000 mPa.s à 25°C, formée d'une succession de motifs choisis parmi ceux de formules :

$SiO_2$ , $HSiO_{1,5}$ , $CH_3(H)SiO$ , $CH_3SiO_{1,5}$ , $(CH_3)_2SiO$ , $(CH_3)_2HSiO_{0,5}$ , $(CH_3)_3SiO_{0,5}$ , $C_6H_5SiO_{1,5}$ , $C_6H_5(CH_3)SiO$ , $(C_6H_5)_2SiO$ , $C_6H_5(CH_3)_2\ SiO_{0,5}$ , $C_6H_5(H)SiO$ , $(C_6H_5)_2CH_3SiO_{0,5}$ ,

et répartis de manière à conduire à des rapports molaires :

$C_6H_5/Si$................ allant de 0,2 à 1,5 de préférence 0,3 à 1,4
$CH_3/Si$................. allant de 0,4 à 2 de préférence 0,5 à 1,9
H/Si................... allant de 0,1 à 1 de préférence 0,2 à 0,9
$(C_6H_5 + CH_3 + H)/Si$... allant de 1,6 à 3 de préférence 1,7 à 2,8

Ce polymère peut être préparé par simple cohydrolyse de mélanges appropriés de chlorosilanes, lesquels chlorosilanes ont évidemment une structure qui est directement en rapport avec celle des motifs établis ci-dessus. En outre pour aider la condensation des groupes SiOH présents dans le milieu réactionnel les cohydrolysats sont de préférence chauffés avec un catalyseur (acide sulfurique, argile activée par un acide) qui non seulement favorise la condensation des groupes SiOH mais également produit un réarrangement des liaisons siloxaniques (brevet français 2 280 956).

Les composés A et B sont employés en quantités suffisantes pour conduire à un rapport molaire des groupes SiH apportés par l'organohydrogénopolysiloxane B, aux groupes à insaturation aliphatique de formule $CH_2{=}CH(R)COQ-$ apportés par le composé A, s'étalant de 0,5 à 7, de préférence de 0,6 à 5. Comme déjà indiqué, au plus 75 moles %,

de préférence au plus 70 moles %, des groupes à insaturation aliphatique ci-dessus peuvent être remplacés par d'autres groupes à insaturation aliphatique apportés par les composés $A_1$.

Le photoinitiateur ou photosensibilisateur C est utilisé à raison de 0,1 à 10 parties, de préférence de 0,5 à 8 parties, pour 100 parties de l'ensemble des composés A et B. Il est choisi par exemple parmi les dérivés de la benzoïne, de la xanthone et de la thioxanthone.

A titre d'exemples concrets de tels photosensibilisateurs peuvent être cités :

- les éthers ou mélanges d'éthers alcoyliques de la benzoïne dans lesquels le radical alcoyle renferme de 1 à 6 atomes de carbone, et plus spécialement les éthers n-propyliques, isopropyliques, n-butyliques, iso butyliques
- la chloro-3 xanthone, la methoxy-3 xanthone
- la chloro-2 thioxanthone.

D'autre types de photosensibilisateurs peuvent être aussi employés comme les dérivés de cétones aromatiques, par exemple l'acétophénone, la benzophénone, la bis(diméthylamino)-4,4' benzophénone. Cependant ces derniers composés donnent parfois de moins bons résultats que les précédents ou alors il faut leur adjoindre un coïnitiateur (par exemple la triéthylamine, le phosphite de triéthyle).

Un diluant organique D, inerte vis-à-vis des composés A, B, C peut être employé à raison d'au plus 150 parties, de préférence d'au plus 140 parties, pour 100 parties de l'ensemble des composés A et B. Ce diluant est utilisé pour faciliter le mélange des constituants A, B et C et également diminuer la viscosité des compositions organopolysiloxaniques de manière qu'elles ne dépassent pas 10 000 mPa.s à 25°C, de préférence 9 000 mPa.s à 25°C. Son emploi n'est pas nécessaire lorsque les constituants A et B sont des produits huileux de viscosité assez faible, par exemple inférieure à 500 mPa.s à 25°C.

Il est choisi parmi les diluants classiques tels que ceux déjà cités pour la préparation des organopolysiloxanes renfermant une certaine proportion de radicaux alcoyles et/ou hydroxyles. Ainsi ces diluants peuvent être des hydrocarbures aliphatiques, cycloaliphatiques, aromatiques, halogénés ou non, parmi lesquels peuvent être cités, à titre illustratif, le n-heptane, le cyclohexane, le méthylcyclohexane, le toluène, le xylène, le perchloroéthylène, le chlorobenzène, les diverses coupes pétrolières.

La préparation des compositions photopolymérisables conformes à l'invention s'effectue par le mélange intime des composants A, B, C et éventuellement D et $A_1$. L'ordre d'introduction des divers constituants n'est pas rigoureux ; il est toutefois préférable de mélanger tout d'abord le constituant A (et éventuellement le constituant $A_1$) et le constituant B, d'agiter le mélange jusqu'à obtention d'un liquide homogène et d'ajouter ensuite le photosensibilisateur.

Le diluant D, lorsqu'il est employé, peut être ajouté au cours du mélange de A et B ou bien il peut être introduit sous forme d'une solution du composé A et/ou du composé B dont il est le solvant.

Les compositions photopolymérisables ainsi obtenues sont applicables (sur toutes sortes de substrat) selon les techniques courantes, par exemple au trempé, à la brosse, à la râcle, au pistolet, par centrifugation. Elles forment (après évaporation du diluant D, lorsqu'elles en comportent) des revêtements homogènes d'épaisseur de quelques microns jusqu'à 200 microns.

Ces revêtements sont durcis par exposition à des radiations ultra-violettes fournies par des lampes à xénon ou à arc à mercure dont le spectre d'émission s'étale généralement de 250 à environ 450 nm ; le temps d'exposition est variable, il peut être de quelque secondes ou s'étendre jusqu'à une centaine de secondes. Il présentent :

- de bonnes propriétes mécaniques, en particulier une résistance élevée aux chocs, à l'emboutissage, une grande ténacité et souplesse,
- une bonne résistance aux solvants,
- une bonne résistance au froid,
- de bonnes propriétés électriques, en particulier une valeur élevée de la rigidité diélectrique,
- une faible thermoplasticité,
- une excellente adhérence aux matériaux qu'ils recouvrent.

Ils peuvent recouvrir, et ainsi protéger, des matériaux d'une nature quelconque ; par exemple :

- les métaux à base de fer, acier, aluminium, cuivre, laiton, bronze, plomb, titane, vanadium, cadmium, silicium

- les polymères organiques constitués de polyoléfines, polyamides, polyuréthannes, polyéthers, polycarbonates, polyepoxydes, polyesters, de résines phénol-formaldehyde, mélamine-formol
- les caoutchoucs organiques et synthétiques constitués de butadiène-styrène, isobutylène-isoprène, acrylonitrile-butadiène, silicone
- les différentes variétés de papier et de carton
- les tissus à base de fibres synthétiques ou naturelles, de verre, d'amiante
- le bois
- les matières minérales à base de silice, de silicates.

Ils sont utilisables dans de nombreux domaines d'application et plus spécialement en électronique pour la protection des circuits imprimés, des circuits intégrés ainsi que des différents montages. L'intérêt de ces revêtements réside, en dehors des propriétés remarquables exposées ci-dessus, dans leur préparation aisée qui ne nécessite pas de températures élevées.

Les exemples suivants illustrent l'invention :

EXEMPLE 1

On charge dans un réacteur équipé d'un agitateur :

- 20 g d'un polymère méthylphénylhydrogénopolysiloxanique $P_1$, constitué de motifs $C_6H_5SiO_{1,5}$ , $(C_6H_5)_2SiO$ , $(CH_3)_3SiO_{0,5}$ , $CH_3(H)SiO$ répartis de manière à conduire à des rapports molaires $CH_3/Si$ , $C_6H_5/Si$ et $H/Si$ ayant respectivement pour valeur 0,75, 0,7 et 0,45, de viscosité 4 000 mPa.s à 25°C, ayant environ 11,3 % de groupes SiH.
- 16,5 g du silane de formule $\left[CH_2=C(CH_3)COOCH_2CH_2O\right]_2Si(C_6H_5)_2$.

Les 20 g du polymère $P_1$ renferment 0,078 mole de groupes SiH et les 16,5 g du silane renferment 0,074 mole de groupes vinyles ; le rapport SiH/Si vinyle est de l'ordre de 1,04. (Les radicaux $CH_2=C(CH_3)-$ sont assimilés à des groupes vinyles).

Les 2 produits sont agités jusqu'à obtention d'une solution homogène puis on ajoute dans le réacteur 1,5 g d'un photoinitiateur $T_1$ constitué de l'éther isopropylique de la benzoïne. L'ensemble est agité pendant 2 heures.

La compositions obtenue, de viscosité 2 200 mPa.s à 25°C, est appliquée par enduction sur l'une des 2 faces de plaques d'aluminium dégraissées. Le revêtement ainsi déposé a une épaisseur de 100 microns. Il est durci par exposition pendant 90 secondes aux radiations ultra-violettes. Ces radiations sont émises par une lampe à vapeur de mercure de puissance 5 000 W équipée d'un réflecteur elliptique. La zone frontale de la lampe est située à une distance de 5,6 cm de la face enduite des plaques d'aluminium. Cette lampe émet principalement dans le proche ultra-violet avec un maximum à 36 nm.

Le revêtement durci présente les caractéristiques suivantes :

- pas de thermoplasticité jusqu'à 140°C ; le test relatif à la détermination de la thermoplasticité consiste à maintenir entre 2 plateaux chauffants, pendant 10 secondes, sous une pression de $5.10^5$ Pa, 2 plaques d'aluminium disposées face enduite contre face enduite et à noter la valeur de la température à partir de laquelle les plaques ne peuvent plus être décollées l'une de l'autre
- pas de modification à -60°C ; le test relatif à la détermination des modifications des caractéristiques physiques à basses températures consiste à placer les plaques d'aluminium enduites dans un caisson à froid qui est régulé de manière à fournir des paliers de températures d'une durée de 24 heures toutes les fois que la température descend de 10 degrés. On note l'aspect des revêtements à chaque paliers ; apparition ou non de craquelures
- pas de solubilité ni dans le trichloroéthylène ni dans le trichlorotrifluoroéthane de formule $CCl_2FCClF_2$ ; le test relatif à la détermination de la solubilité consiste à immerger les plaques d'aluminium enduites, dans le solvant pendant 4 heures, à la température ambiante. Après séchage à l'air on note l'aspect des revêtements : pas de modifications, zones fragilisées, apparition de cloques, dissolution complète
- une rigidité diélectrique de 100 kV/mm ; pour mesurer cette rigidité on utilise des électrodes de diamètre 6,35 mm, une montée de la tension de 500 volts/seconde et un courant alternatif de 500 Hz.

EXEMPLE 2

On charge dans un réacteur équipé d'un agitateur :

- 20 g du polymère méthylphénylhydrogénopolysiloxanique $P_1$ utilisé à l'exemple 1
- 4,56 g du silane de formule $[CH_2=C(CH_3)COOCH_2CH_2O]_2Si(C_6H_5)_2$
- 4,44 g du composé insaturé de formule
  $[CH_2=C(CH_3)COOCH_2CH_2OC_6H_4]_2C(CH_3)_2$

Les 20 g du polymère $P_1$ renferment 0,078 mole de groupes SiH, les 4,56 g du silane renferment 0,0206 mole de groupes vinyles et les 4,44 g du composé insaturé renferment 0,0196 mole de groupes vinyles : le rapport molaire SiH/Si vinyle est de l'ordre de 1,9.

Les 3 produits sont agités jusqu'à obtention d'un produit homogène auquel on ajoute 1,16 g du photoinitiateur $T_1$ utilisé à l'exemple 1. L'ensemble est agité pendant 1h30.

La composition obtenue, de viscosité 3100 mPa.s à 25°C, est appliquée par trempage sur la surface de circuits imprimés à 2 branches, chaque circuit étant disposé sur une face d'une plaque constituée d'un stratifié verre-résine epoxyde. Le revêtement ainsi formé, d'épaisseur 30 microns environ, est durci par photoréticulation dans les conditions d'exposition aux radiations ultra-violettes figurant à l'exemple 1.

La résistance d'isolement de chaque circuit imprimé est mesurée sous une tension de 500 V après abandon de chaque plaque à l'air ambiant (la température est de 20°C et l'humidité relative de 50 %). Elle atteint 800 x $10^{10}$ ohm.cm et reste pratiquement à cette valeur quel que soit le nombre de jours d'abandon à ces conditions de température et d'humidité.

La résistance d'isolement est alors mesurée sous la même tension mais après exposition de chaque plaque à une température de 45°C et à une humidité relative de 95 %. Elle atteint 580 x $10^{10}$ ohm.cm après 10 jours d'exposition et 25 x $10^{10}$ ohm.cm après 56 jours d'exposition. Ces valeurs sont élevées bien que les conditions d'environnement soient sévères ; elles montrent le bon caractère isolant et la bonne adhérence du revêtement sur les circuits imprimés.

EXEMPLE 3

On charge dans un réacteur équipé d'un agitateur :

- 20 g du polymère méthylphénylhydrogénopolysiloxanique $P_1$ utilisé à l'exemple 1
- 12,45 g du silane de formule $[CH_2=C(CH_3)COOCH_2CH_2O]_2Si(C_6H_5)_2$
- 7,6 g du polymère méthylphénylvinylpolysiloxanique constitué de motifs $(CH_3)SiO_{1,5}$ ; $(CH_3)_2SiO$ ; $CH_3(CH=CH)SiO$ ; $(C_6H_5)_2SiO$ ; répartis de manière à conduire à des rapports molaires $CH_3/Si$, $C_6H_5/Si$ et vinyl/Si ayant respectivement pour valeur 0,8 , 0,75 et 0,3 de viscosité 3500 mPa.s à 25°C, ayant environ 6 % de groupes vinyles.

Les 20 g du polymère $P_1$ renferment 0,078 mole de groupes SiH, les 12,45 g du silane renferment 0,056 mole de groupes vinyles et les 7,6 g du polymère méthylphénylvinylpolysiloxanique renferment 0,016 mole de groupes vinyles : le rapport molaire SiH/Si vinyle est de l'ordre de 1,1.

Les 3 produits sont agités jusqu'à obtention d'un liquide homogène auquel on ajoute 1,6 g du photoinitiateur utilisé à l'exemple 1. L'ensemble est agité pendant 2 heures.

La composition obtenue, de viscosité 2600 mPa.s à 25°C, est appliquée par centrifugation sur l'une des faces de plaques d'aluminium dégraissées ; le revêtement ainsi formé, d'épaisseur 100 microns, est durci par photoréticulation dans les conditions d'exposition aux radiations ultra-violettes figurant à l'exemple 1.

Ce revêtement possède les propriétés du revêtement décrit à l'exemple 1 : pas de thermoplasticité jusqu'à 140°C, pas de changement dans les caractéristiques physiques à -60°C, pas de solubilité ni dans le trichloroéthylène ni dans le trichlorotrifluoroéthylène de formule $CCl_2FCClF_2$, et une rigidité diélectrique de 100 kV/mm.

La composition est également appliquée par pulvérisation non plus sur des plaques d'aluminium mais sur l'une des faces de plaques de silice. Le revêtement formé, d'épaisseur 25 microns, est durci par photoréticulation dans les conditions d'exposition aux radiations ultra-violettes figurant à l'exemple 1.

On constate une très bonne adhérence (note 5) du revêtement. Cette adhérence est mesurée selon un test de quadrillage qui satisfait à la norme NF 30 038. Ce test est le suivant : au moyen d'un peigne de grattage, dont les dents sont espacées de 1 mm, on forme un quadrillage sur le revêtement, les incisions étant effectuées jusqu'au support. On applique alors sur les petits carrés de 1 $mm^2$ ainsi formés un ruban adhésif ; le ruban est ensuite enlevé et on examine l'état du revêtement. Cet état est apprécié selon une notation de 1 à 5 :

Note 5 : pas de zone du revêtement détachée

Note 4 : de petites zones du revêtement se sont détachées qui représentent environ 5 % de la surface totale

Note 3 : des zones du revêtement se sont détachées qui représentent environ 15 % de la surface totale

Note 2 : de larges zones du revêtement se sont détachées qui représentent environ 35 % de la surface totale

Note 1 : des zones très importantes du revêtement se sont détachées qui représentent environ 65 % de la surface totale.

D'autre part, l'adhérence reste bonne après exposition du revêtement à 32 cycles de vieillissement accéléré au Weatherometer.

EXEMPLE 4

On charge dans un réacteur équipé d'un agitateur :

- 20 g du polymère méthylphénylhydrogénopolysiloxanique $P_1$ utilisé à l'exemple 1
- 23,2 g du trisiloxane de formule

$$[CH_2=C(CH_3)COOCH_2CH_2OSi(CH_3)_2O]_2Si(C_6H_5)_2$$

Les 20 g du polymère $P_1$ renferment 0,078 mole de groupes SiH, les 23,2 g du trisiloxane renferment 0,08 mole de groupes vinyles : le rapport molaire SiH/Si vinyle est de l'ordre de 1.

Les 2 produits sont agités jusqu'à obtention d'un liquide homogène auquel on ajoute 1,7 g du photoinitiateur $T_1$ utilisé à l'exemple 1. L'ensemble est agité pendant 1h45mn.

La composition obtenue, de viscosité 1900 mPa.s à 25°C, est appliquée par enduction sur l'une des faces de plaques d'acier dégraissées. Le revêtement ainsi formé a une épaisseur de 15 microns ; il est durci par exposition aux radiations ultra-violettes dans les conditions d'exposition figurant à l'exemple 1 sauf que la durée d'exposition est de 60 secondes au lieu de 90 secondes.

On constate une très bonne adhérence du revêtement sur les plaques d'acier (note 5). Cette adhérence est mesurée selon le test de quadrillage décrit décrit à l'exemple 3. On constate également une très bonne résistance du revêtement aux chocs (note 5). Cette résistance est mesurée selon un test qui dérive de la norme NF 30 039. Ce test est le suivant : le revêtement est soumis au choc d'une masse d'acier de 1 kg, choc provoqué par la chute verticale guidée de cette masse d'une hauteur de 50 cm. On applique un ruban adhésif sur la zone d'impact. Après enlèvement du ruban, on examine l'état du revêtement et l'apprécie en utilisant la notation du test de quadrillage, décrite à l'exemple 3.

EXEMPLE 5

(e) Dans un réacteur équipé d'une agitation, d'une gaine thermométrique et d'un col de cygne surmonté d'un analyseur, on charge :

- 70 g d'un polymère méthylphénylpolysiloxanique solide constitué de motifs $C_6H_5SiO_{1,5}$ , $(CH_3)_2SiO$ et $CH_3SiO_{1,5}$ répartis de manière à conduire à des rapports molaire $C_6H_5/Si$ et $CH_3/Si$ ayant chacun pour valeur 0,625, de point de fusion 80°C, renfermant environ 5 % de groupes OH
- 19 g du silane de formule $CH_2=C(CH_3)COO(CH_2)_3Si(OCH_3)_3$
- 30 g de toluène
- 0,18 g de titanate de tétraisopropyle

Les 70 g du polymère méthylphénylpolysiloxanique renferment 0,206 mole de groupes OH et les 19 g du silane renferment 0,228 mole de groupes methoxy : le rapport molaire $OH/OCH_3$ est de l'ordre de 0,9.

Le contenu du réacteur est chauffé progressivement de 20°C à 135°C en une période de 50 minutes ; au cours de ce chauffage des produits volatils sont éliminés et en particulier 4,7 g de méthanol ; cette quantité représente 71 % de la quantité théorique attendue laquelle s'élève à 6,59 g.

Le condensat homogène obtenu a une viscosité de 1000 mPa.s à 25°C ; il renferme environ 25 % de toluène et 0,07 mole de groupes vinyles par 100 g.

(2e) Dans un réacteur équipé d'une agitation, on charge :

- 20 g du polymère méthylphénylhydrogénopolysiloxanique $P_1$ utilisé à l'exemple 1

- 55 g du condensat ci-dessus

Les 20 g du polymère $P_1$ renferment 0,078 mole de groupes SiH et les 55 g du condensat 0,038 mole de groupes vinyles : le rapport molaire SiH/Si vinyle est de l'ordre de 2.

Les 2 produits sont agités jusqu'à obtention d'un liquide homogène, contenant 18,1 % de toluène, auquel on ajoute 2,47 g du photoinitiateur $T_1$ utilisé à l'exemple 1. L'ensemble est agité pendant 2 heures.

La composition obtenue, de viscosité 1800 mPa.s à 25°C, est déposée par enduction sur l'une des faces de plaques d'aluminium dégraissées. La couche déposée est séchée par passage des plaques sous une hotte ventilée. Il reste un revêtement d'épaisseur 75 microns qui est durci par photoréticulation dans les conditions d'exposition aux radiations ultra-violettes figurant à l'exemple 1 ; toutefois la durée d'exposition est seulement de 12 secondes.

Le revêtement des plaques est soumis aux essais suivants :

- adhérence au test du quadrillage ........................ NOTE 3
  (ce test est celui décrit à l'exemple 3)
- résistance aux chocs ..................................... NOTE 5
  (ce test de résistance aux chocs est celui décrit à l'exemple 4)
- résistance à l'emboutissage (test Erichsen) .............. NOTE 3

La résistance à l'emboutissage est mesurée selon un test qui dérive de la norme NF 30 019.

Ce test est le suivant : le revêtement est tout d'abord quadrillé en carrés de 1 $mm^2$ à l'aide du peigne de grattage utilisé pour l'exécution du test de quadrillage, les incisions étant effectuées jusqu'au support. Le revêtement ainsi quadrillé est soumis à un emboutissage progressif de 5 mm. On applique un ruban adhésif sur la zone d'emboutissage ; après enlèvement du ruban on examine l'état du revêtement et l'apprécie selon la notation du test de quadrillage décrite à l'exemple 3.

A titre comparatif on fabrique un revêtement semblable d'épaisseur 75 microns mais à partir d'une composition contenant seulement le condensat ; ainsi cette composition est obtenue par mélange de 75 g du condensat avec 2,47 g du photoinitiateur $T_1$.

Ce nouveau revêtement est soumis aux tests précédents : les notes sont les suivantes :

- adhérence au test de quadrillage : ...........................1
- résistance aux chocs : .........................................1
- résistance à l'emboutissage (test Erichsen) : ................1

L'absence du polymère méthylphénylhydrogénopolysiloxanique $P_1$ dans la composition ne permet donc pas de fabriquer un revêtement ayant de bonnes propriétés.

EXEMPLE 6

Dans un réacteur équipé d'une agitation, on charge :

- 20 g du polymère méthylphénylhydrogénopolysiloxanique $P_1$ utilisé à l'exemple 1
- 22 g du condensat préparé à l'exemple 5 sous (e)

Les 20 g du polymère $P_1$ renferment 0,078 mole de groupes SiH et les 22 g du condensat renferment 0,0154 mole de groupes vinyles : le rapport molaire SiH/Si vinyle est de l'ordre de 5.

Les 2 produits sont agités jusqu'à obtention d'un liquide homogène auquel on ajoute 1,38 g du photoinitiateur $T_1$. L'ensemble est agité pendant 1h30.

La composition obtenue, de viscosité 2400 mPa.s à 25°C, est appliquée par enduction sur l'une des 2 faces de plaques d'aluminium dégraissées puis la couche déposée est séchée. Le revêtement formé, d'épaisseur 75 microns est durci selon les conditions d'exposition aux radiations ultra-violettes figurant à l'exemple 1, toutefois la durée d'exposition est seulement de 12 secondes. Ce revêtement est soumis aux mêmes tests que ceux mis en oeuvre à l'exemple 5. Les notes sont les suivantes :

- adhérence au test de quadrillage : ...........................5
- résistance aux chocs : .........................................4
- résistance à l'emboutissage (test Erichsen) : ................5

EXEMPLE 7

(f) Dans un réacteur équipé d'un agitateur d'une gaine thermométrique et d'un col de cygne surmonté d'un analyseur, on charge :

- 200 g de l'acrylate d'hydroxyéthyle de formule $CH_2=CH-COO-CH_2CH_2OH$
- 471 g d'un polymère méthylphénylpolysiloxanique $P_2$ constitué de motifs $C_6H_5SiO_{1,5}$ , $(C_6H_5)_2SiO$ et $(CH_3)_2SiO$ répartis de manière à conduire à des rapports molaire $C_6H_5/Si$ et $CH_3/Si$ ayant respectivement pour valeur 0,9 et 0,7 , de viscosité 125 mPa.s à 25°C, renfermant environ 12,6 % de groupes methoxyles.

- 1,34 g de titanate d'isopropyle

Les 200 g d'acrylate d'hydroxyéthyle renferment 1,72 mole de groupes OH et les 471 g du polymère $P_2$ renferment 1,91 mole de groupes $OCH_3$ : le rapport molaire $OH/OCH_3$ est de l'ordre de 0,9.

Le contenu du réacteur est porté progressivement de 20°C à 125°C dans une période de 55 minutes . Au cours de ce chauffage 8,1 g de méthanol sont éliminés. Cette quantité représente 14,7 % de la quantité théorique attendue de méthanol, laquelle s'élève à 55,04 g.

Le condensat homogène obtenu a une viscosité de 80 mPa.s à 25°C ; il renferme environ 0,259 mole de groupes vinyliques par 100 g.

(2f) Dans un réacteur équipé d'une agitation, on charge :

- 20 g du polymère méthylphénylhydrogénopolysiloxanique $P_1$ utilisé à l'exemple 1
- 29,7 g du condensat ci-dessus

Les 20 g du polymère $P_1$ renferment 0,078 mole de groupes SiH et les 29,7 g du condensat renferment 0,077 mole de groupes vinyles : le rapport molaire SiH/Si vinyle est de l'ordre de 1.

Les 2 produits sont agités jusqu'à obtention d'un liquide homogène auquel on ajoute 1,98 g du photoinitiateur $T_1$ utilisé à l'exemple 1. L'ensemble est agité pendant 1 heure.

La composition obtenue, de viscosité 1600 mPa.s à 25°C, est appliquée par enduction sur l'une des 2 faces de plaques d'aluminium préalablement dégraissées. Le revêtement déposé, d'épaisseur 20 microns, est durci par photoréticulation dans les conditions d'exposition aux radiations ultra-violettes figurant à l'exemple 1, excepté que la durée d'exposition est seulement de 30 secondes.

Ce revêtement est soumis aux mêmes tests que ceux mis en oeuvre à l'exemple 5. Les notes sont les suivantes :

- adhérence au test du quadrillage .......................... 5
- résistance aux chocs ........................................ 4
- résistance à l'emboutissage (test Erichsen) .............. 5

EXEMPLE 8

Dans un réacteur équipé d'une agitation, on charge :

- 20 g du polymère méthylphénylhydrogénopolysiloxanique $P_1$ utilisé à l'exemple 1
- 7,30 g du condensat préparé à l'exemple 7 sous (f)
- 7,30 g du composé insaturé de formule

$$[CH_2=C(CH_3)COOCH_2CH_2OC_6H_4]_2C(CH_3)_2$$

Les 20 g du polymère $P_1$ renferment 0,078 mole de groupes SiH et les 7,30 g du condensat 0,019 mole de groupes vinyles et les 7,30 g du composé insaturé renferment 0,032 mole de groupes vinyles : le rapport molaire SiH/Si-vinyle est de l'ordre de 1,5.

Les 3 produits sont agités jusqu'à obtention d'un liquide homogène auquel on ajoute 1,38 g du photoinitiateur $T_1$ utilisé à l'exemple 1. L'ensemble est agité pendant 1 heure.

La composition obtenue, de viscosité 2700 mPa.s à 25°C, est appliquée par enduction sur l'une des 2 faces de plaques d'aluminium préalablement dégraissées. Le revêtement ainsi formé, d'épaisseur 20 microns, est durci par photoréticulation dans les conditions d'exposition aux radiations ultra-violettes figurant à l'exemple 1. Ce revêtement est soumis aux mêmes tests que ceux mis en oeuvre à l'exemple 5. Les notes sont les suivantes :

- adhérence au test du quadrillage ........................ 5
- résistance aux chocs .................................. 5
- résistance à l'emboutissage (test Erichsen) ............. 5

A titre comparatif on fabrique un revêtement semblable, d'épaisseur 20 microns, mais on part d'une composition ne contenant pas le polymère $P_1$ (on remplace les 20 g de ce polymère par 10 g du condensat et 10 g du composé insaturé). Ce nouveau revêtement est soumis aux tests ci-avant. Les notes sont les suivantes :

- adhérence au test du quadrillage ........................ 3
- résistance aux chocs .................................. 5
- résistance à l'emboutissage (test Erichsen) ............. 3

EXEMPLE 9

Dans un réacteur équipé d'une agitation, on charge :

- 20 g du polymère méthylphénylhydrogénopolysiloxanique $P_1$ utilisé à l'exemple 1

- 5,5 g du condensat préparé à l'exemple 7 sous (f)
- 5,5 g du composé insaturé de formule

$$\left[CH_2=C(CH_3)COOCH_2CH_2OC_6H_4\right]_2C(CH_3)_2$$

Les 20 g du polymère $P_1$ renferment 0,078 mole de groupes SiH, les 5,5 g du condensat renferment 0,014 mole de groupes vinyles et les 5,5 g du composé insaturé renferment 0,024 mole de groupes vinyles : le rapport molaire SiH/Si vinyle est de l'ordre de 2.

Les 3 produits sont agités jusqu'à obtention d'un liquide homogène auquel on ajoute 1,24 g du photoinitiateur $T_1$ utilisé à l'exemple 1. L'ensemble est agité pendant 1 heure.

La composition obtenue, de viscosité 3000 mPa.s à 25°C, est appliquée par enduction sur l'une des 2 faces de plaques d'aluminium préalablement dégraissées. Le revêtement formé, d'épaisseur 40 microns, est durci selon les conditions d'exposition aux radiations ultra-violettes figurant à l'exemple 1. Ce revêtement est soumis aux mêmes tests que ceux décrits à l'exemple 5. Les notes des 3 tests atteignent 5.

EXEMPLE 10

(g) Dans un réacteur équipé d'une agitation, d'une gaine thermométrique et d'un col de cygne surmonté d'un analyseur, on charge :

- 40 g de l'acrylate de propylèneglycol de formule $CH_2=CH-COOCH_2CHOH-CH_3$
- 75,5 g du polymère méthylphénylpolysiloxanique $P_2$ utilisé à l'exemple 7
- 0,23 g de titanate de tétraisopropyle

Les 40 g d'acrylate d'hydroxyéthyle renferment 0,3 mole de groupes hydroxyles et les 75,5 g du polymère $P_2$ renferment 0,29 mole de groupes methoxyles : le rapport molaire $OH/OCH_3$ est de l'ordre de 1.

Le contenu du réacteur est porté progressivement de 20°C à 160°C en une période de 1 heure. Au cours de ce chauffage on élimine 5,2 g de méthanol qui représente 54 % de la quantité théorique attendue de méthanol, laquelle s'élève à 9,6 g. Le condensat homogène ainsi formé a une viscosité de 520 mPa.s à 25°C ; il renferme environ 0,278 mole de groupes vinyles par 100 g.

(2g) Dans un réacteur équipé d'une agitation, on charge :

- 20 g du polymère méthylphénylhydrogénopolysiloxanique $P_1$ utilisé à l'exemple 1
- 27 g du condensat ci-dessus

Les 20 g du polymère $P_1$ renferment 0,078 mole de groupes SiH et les 27 g du condensat 0,075 mole de groupes vinyles : le rapport molaire SiH/Si vinyle est de l'ordre de 1.

Ce mélange est agité jusqu'à obtention d'un liquide homogène auquel on ajoute ensuite 1,88 g du photoinitiateur $T_1$, utilisé à l'exemple 1 ; l'ensemble est agité pendant 1 heure.

La composition obtenue, de viscosité 2000 mPa.s à 25°C, est appliquée par pulvérisation sur l'une des 2 faces de plaques d'aluminium dégraissées. Le revêtement déposé, d'épaisseur 36 microns, est durci par photoréticulation dans les conditions d'exposition aux radiations ultra-violettes figurant à l'exemple 1, excepté que la durée d'exposition est seulement de 60 secondes. Ce revêtement est soumis aux mêmes tests que ceux décrits à l'exemple 5. Les notes sont les suivantes :

- adhérence au test du quadrillage ........................ 5
- résistance aux chocs .................................... 5
- résistance à l'emboutissage (test Erichsen) .............. 5

EXEMPLE 11

(h) Dans un réacteur équipé d'une agitation, d'une gaine thermométrique et d'un col de cygne surmonté d'un analyseur, on charge :

- 37,5 g de triacrylate de pentaerythritol de formule $(CH_2=CH-COOCH_2)_3C-CH_2OH$
- 31,20 g du polymère méthylphénylpolysiloxanique $P_2$ utilisé à l'exemple 7
- 5 g de toluène
- 0,14 g de titanate de tétraisopropyle

Les 37,5 g du triacrylate de pentaerythritol renferment 0,126 mole de groupes hydroxyles et les 31,20 g du polymère $P_2$ renferment 0,127 mole de groupes methoxyles : le rapport molaire $OH/OCH_3$ est de l'ordre de 1.

Le contenu du réacteur est porté progressivement de 20°C à 120°C en une période de 1 heure 10 minutes. Au cours de ce chauffage

on élimine des composés volatils, en particulier 0,5 g de méthanol ce qui représente 12,4 % de la quantité théorique attendue de méthanol, laquelle s'élève à 4,03 g. Le condensat obtenu a une viscosité de 200 mPa.s à 25°C ; il renferme environ 0,513 mole de groupes vinyles par 100 g.

(2h) Dans un réacteur équipé d'une agitation, on charge :
- 20 g du polymère méthylphénylhydrogénopolysiloxanique $P_1$ utilisé à l'exemple 1
- 14 g du condensat ci-dessus

Les 20 g du polymère $P_1$ renferment 0,078 mole de groupes SiH et les 14 g du condensat renferment 0,077 mole de groupes vinyles : le rapport molaire SiH/Si vinyle est de l'ordre de 1.

Le mélange est agité jusqu'à obtention d'un liquide homogène auquel on ajoute ensuite 1,32 g du photoinitiateur $T_1$, utilisé à l'exemple 1. L'ensemble est agité pendant 1h30.

La composition obtenue, de viscosité 2200 mPa.s à 25°C, est appliquée par centrifugation sur l'une des 2 faces de plaques d'aluminium dégraissées. Le revêtement déposé présente, après séchage à l'air, une épaisseur de 50 microns. Il est durci par photoréticulation dans les conditions d'exposition aux radiations ultra-violettes figurant à l'exemple 1 ; toutefois la durée d'exposition est seulement de 40 secondes.

Ce revêtement est soumis aux mêmes tests que ceux mis en oeuvre à l'exemple 5. Les notes sont les suivantes :
- adhérence au test du quadrillage ........................ 5
- résistance aux chocs ..................................... 4
- résistance à l'emboutissage (test Erichsen) ............. 4

A titre comparatif on fabrique un revêtement semblable, d'épaisseur 50 microns, durci dans les mêmes conditions, mais à partir d'une composition contenant seulement le condensat (cette composition est obtenue par mélange de 34 g du condensat avec 1,32 g du photoinitiateur $T_1$). Ce nouveau revêtement est soumis aux tests précédents ; les notes sont les suivantes :
- adhérence au test du quadrillage ........................ 1
- résistance aux chocs ..................................... 1
- résistance à l'emboutissage (test Erichsen) ............. 1

EXEMPLE 12

(i) Dans un réacteur équipé d'une agitation, d'une gaine thermométrique et d'un col de cygne surmonté d'un analyseur, on charge :

- 10 g de l'amide de formule $CH_2=CH-CONH-CH_2OH$, de point de fusion 75°C
- 22,2 g du polymère méthylphénylpolysiloxanique $P_2$ utilisé à l'exemple 7 (toutefois il contient 13,8 % de groupes methoxyles au lieu de 12,6 %)
- 20 g de diméthylformamide
- 0,06 g de titanate d'isopropyle

Les 10 g d'amide renferment 0,099 mole de groupes hydroxyles et les 22,2 g du polymère $P_2$ renferment 0,099 mole de groupes methoxyles : le rapport molaire $OH/OCH_3$ est de l'ordre de 1.

Le contenu du réacteur est porté progressivement de 20°C à 138°C en une période de 1 heure. Au cours de ce chauffage on élimine 0,32 g de méthanol soit 10 % de la quantité de méthanol théoriquement attendue. Le diméthylformamide est enlevé du condensat par chauffage sous pression réduite à une température ne dépassant pas 90°C. Le condensat est un produit solide, de point de ramollissement 70°C, renfermant 0,309 mole de groupes vinyles par 100 g.

(2i) Dans un réacteur équipé d'une agitation, on charge :

- 20 g du polymère méthylphénylhydrogénopolysiloxanique $P_1$ utilisé à l'exemple 1
- 22,4 g du condensat ci-dessus

Les 20 g du polymère $P_1$ renferment 0,078 mole de groupes SiH et les 22,4 g du condensat 0,069 mole de groupes vinyles : le rapport molaire SiH/Si vinyle est de l'ordre de 1.

Ce mélange est agité jusqu'à obtention d'un liquide homogène auquel on ajoute ensuite 1,77 g du photoinitiateur $T_1$, décrit à l'exemple 1. L'ensemble est agité pendant 1 heure.

La composition obtenue, de viscosité 5000 mPa.s à 25°C, est appliquée par trempage sur la surface de plaques d'aluminium dégraissées. Le revêtement déposé a une épaisseur 60 microns. Il est durci sur une face des plaques par photoréticulation dans les conditions d'exposition aux radiations ultra-violettes figurant à l'exemple 1, excepté que la durée d'exposition est de 30 secondes. Le revêtement durci est soumis aux mêmes tests que ceux mis en oeuvre à

l'exemple 5. Les notes sont les suivantes :

- adhérence au test du quadrillage ........................ 5
- résistance aux chocs .................................... 5
- résistance à l'emboutissage (test Erichsen) ............. 5

REVENDICATIONS

1) Compositions organopolysiloxaniques liquides, de viscosité allant de 100 mPa.s à 25°C à 10 000 mPa.s à 25°C, photopolymérisables, formées par mélange de :

A/ au moins un composé organosilicique, monomère ou polymère, portant liés à son, ou ses atomes de silicium

1) au moins un radical organique renfermant un groupe non saturé de formule $CH_2 = C(R)COQ-$ dans laquelle le symbole R représente un atome d'hydrogène, le radical méthyle, et le symbole Q représente O, NH,

2) au moins un radical phényle

les autres radicaux organiques étant choisis dans le groupe constitué des radicaux méthyles, éthyles, propyles, trifluoro-3,3,3 propyles, vinyles, alcoxyles ayant de 1 à 5 atomes de carbone, ß-methoxyethoxyles, hydroxyles.

B/ au moins un organohydrogénopolysiloxane portant liés à ses atomes de silicium au moins un atome d'hydrogène et au moins un radical phényle, les autres radicaux étant des radicaux méthyles -

les composés A et B étant employés en quantités suffisantes pour conduire à un rapport molaire des groupes SiH, apportés par l'organohydrogénopolysiloxane B, aux groupes $CH_2$=CRCOQ-, apportés par le composé A, s'étalant de 0,5 à 7.

C/ un photosensibilisateur choisi parmi les dérivés de la benzoïne, de la xanthone ou de la thioxanthone, à raison de 0,1 à 10 parties pour 100 parties de l'ensemble des composés A et B

D/ un diluant organique, inerte vis-à-vis des composés A, B et C, à raison de 0 à 150 parties pour 100 parties de l'ensemble des composés A et B.

2) Compositions selon la revendication 1 caractérisées en ce que le composé A est choisi parmi les silanes de formules générales :

$$\left[CH_2=C(R)COQG(O)_a\right]_b SiR'_c R''_{4-b-c}$$

$$\left[CH_2=C(R)COQCH_2\right]_{b'} G'OSiR'_c R''_{3-c}$$

dans lesquelles

- les symboles R et Q ont la signification donnée dans la revendication 1
- le symbole G représente des radicaux alcoylènes divalents, linéaires ou ramifiés, ayant de 1 à 5 atomes de carbone,
- le symbole G' représente des radicaux alcoylènes tri ou tétravalents, linéaires ou ramifiés, ayant de 1 à 5 atomes de carbone,
- le symbole R' représente un radical méthyle, éthyle, propyle, phényle, vinyle, phényle, trifluoro-3,3,3 propyle,
- le symbole R" représente un radical alcoxyle ayant de 1 à 5 atomes de carbone, un radical β-methoxyethoxyle,
- le symbole a représente zéro ou 1,
- le symbole b représente 1, 2 ou 3 quand a = 1, il représente seulement 1 quand a = zéro,
- le symbole c représente 1, 2 ou 3
- le symbole b' représente 2 ou 3

au moins un radical R' représente un radical phényle.

3) Compositions selon la revendication 1 caractérisées en ce que le composé A est choisi parmi les polymères organopolysiloxaniques linéaires ou ramifiés, liquides, de viscosité au plus 30 000 mPa.s à 25°C, ou solides de point de fusion inférieur à 120°C, constitués de deux classes de polymères, la première classe étant des polymères ne renfermant pratiquement pas de radicaux alcoxyles et/ou hydroxyles liés aux atomes de silicium, la deuxième classe étant des polymères renfermant ces radicaux.

4) Compositions selon la revendication 3 caractérisées en ce que les polymères organopolysiloxaniques de la première classe sont constitués de :

- de 1 à 100 moles % de motifs choisis parmi ceux de formules :

$$CH_2=C(R)COQG(O)_aSiR'_dO_{\frac{3-d}{2}}$$

$$\left[CH_2=C(R)COQCH_2\right]_{b'}G'OSiR'_dO_{\frac{3-d}{2}}$$

dans lesquelles les symboles R, Q, R', G, G', a et b' ont la même signification donnée dans la revendication 2 et le symbole d représente 1 ou 2

- de 99 à 0 moles % de motifs de formule $R'_fSiO_{\frac{4-f}{2}}$

dans laquelle le symbole R' a la signification donnée dans la revendication 2 , le symbole f représente 1, 2 ou 3 ;
le rapport molaire (R' + Z)/Si, s'étend de 1,4 à 3, le symbole Z représentant des radicaux de formules générales :

$$CH_2=C(R)COQG(O-)_a$$
$$(CH_2=C(R)COQCH_2)_{b'}G'O- \quad ,$$

5 moles % de radicaux R', de préférence 10 moles %, sont des radicaux phényles.

5) Compositions selon la revendication 3 caractérisées en ce que les organopolysiloxanes de la deuxième classe sont préparés selon un procédé selon lequel :

(1) on met en contact

- soit des organopolysiloxanes formés de motifs de formule

$$R'_fSiO_{\frac{4-f}{2}}$$

dans laquelle les symboles R' et f ont la signification donnée dans la revendication 4, ayant un rapport molaire R'/Si allant de 1,1 à 2,1 et contenant de 2 à 10 % de radicaux hydroxyles liés aux atomes de silicium, au moins 5 moles % des radicaux R' étant des radicaux phényles

- avec des silanes choisis parmi ceux de formules :

$$CH_2=C(R)COQG(O)_aSiR'_eR'''_{4-e}$$

$$\left[CH_2=C(R)COQCH_2\right]_{b'}G'OSiR'_eR'''_{3-e}$$

dans lesquelles les symboles R, Q, G, G', R', a et b' ont la signification donnée dans la revendication 2 et le symbole R''' représente un radical methoxyle, ethoxyle, et le symbole e représente zéro ou 1 ; les organopolysiloxanes et les silanes sont employés

en quantité suffisante pour conduire à un rapport molaire des radicaux hydroxyles apportés par les organopolysiloxanes, aux radicaux methoxyles et/ou ethoxyles apportés par les silanes, s'étalant de 0,7 à 1,3.

(2) puis porte l'ensemble, en présence d'un catalyseur, dans un domaine de températures allant de 15 à 170°C, pendant une durée suffisante pour éliminer au plus 75 % de la quantité théorique de l'alcool attendu (méthanol et/ou éthanol).

6) Compositions selon la revendication 3 caractérisées en ce que les organopolysiloxanes de la deuxième classe sont préparés selon un procédé selon lequel :

(1) on met en contact

- des organopolysiloxanes formés des motifs de formule

$$R'_{f}SiO_{\frac{4-f}{2}}$$

dans laquelle les symboles R' et f ont la même signification que celle donnée dans la revendication 4, ayant le même rapport molaire R'/Si allant de 1,1 à 2,1 et contenant de 5 à 17 % de groupes methoxyles et/ou ethoxyles, au moins 5 moles % des radicaux R' étant des radicaux phényles,

- avec des composés organiques hydroxylés insaturés, choisis parmi ceux de formules :

$$CH_2{=}C(R)COQGOH$$

$$\left[CH_2{=}C(R)COQCH_2\right]_{b'}G'OH$$

dans lesquelles les symboles R, Q, G, G', b' ont la signification donnée à la revendication 2 ; les organopolysiloxanes et les silanes étant employés en quantité suffisante pour conduire à un rapport molaire des radicaux hydroxyles apportés par les composés organiques insaturés, aux radicaux methoxyles et/ou ethoxyles apportés par les organopolysiloxanes, s'étalant de 0,7 à 1,3.

(2) puis porte l'ensemble, en présence d'un catalyseur, dans un domaine de températures allant de 15 à 170°C, pendant une durée suffisante pour éliminer au plus 75 % de la quantité théorique de l'alcool attendu (méthanol et/ou éthanol).

7) Compositions selon l'une quelconque des revendications 1 à 6 caractérisées en ce qu'une fraction du composé A est remplacée par un composé $A_1$ choisi parmi :

- les dérivés du bisphénol A de formule $\left[CH_2=C(R)COO-CH_2CH_2OC_6H_4\right]_2C(CH_3)_2$ dans laquelle le symbole R représente un atome d'hydrogène, un radical méthyle
- des polymères organopolysiloxaniques formés de 2 à 60 moles % de motifs de formule

$$CH_2=CH(R_1)_gSiO_{\frac{3-g}{2}}$$

et de 98 à 40 moles % de motifs de formule

$$(R_1)_{g'}SiO_{\frac{4-g'}{2}}$$

dans lesquelles formules le symbole $R_1$ représente un radical méthyle, phényle, le symbole g représente zéro, 1 ou 2, le symbole g' représente 1,2 ou 3, le rapport molaire $(R_1 + CH_2=CH)/Si$ s'étend de 1,4 à 2,3, au moins 5 moles % des radicaux $R_1$ sont des radicaux phényles, le composé $A_1$ fournissant au plus 75 moles % des groupes à insaturation aliphatique mis en oeuvre dans les compositions.

8) Compositions selon la revendication 1 caractérisées en ce que l'organohydrogénopolysiloxane B est une huile de viscosité au plus 100 000 mPa.s à 25°C, formée d'une succession de motifs choisis parmi ceux de formules :

$SiO_2$ , $HSiO_{1,5}$ , $CH_3(H)SiO$ , $CH_3SiO_{1,5}$ , $(CH_3)_2SiO$ , $(CH_3)_2HSiO_{0,5}$ , $(CH_3)_3SiO_{0,5}$ , $C_6H_5SiO_{1,5}$ , $C_6H_5(CH_3)SiO$ , $(C_6H_5)_2SiO$ , $C_6H_5(CH_3)_2SiO_{0,5}$ , $C_6H_5(H)SiO$ , $(C_6H_5)_2CH_3SiO_{0,5}$ ,

et répartis de manière à conduire à des rapports molaires :

$C_6H_5/Si$...................... allant de 0,2 à 1,5
$CH_3/Si$....................... allant de 0,4 à 2
$H/Si$........................ allant de 0,1 à 1
$(C_6H_5 + CH_3 + H)/Si$.......... allant de 1,6 à 3

9) Revêtements protecteurs sur les matériaux solides caractérisés en ce qu'ils sont obtenus par application, puis photopolymérisation à l'aide de radiations ultra-violettes, des compositions selon l'une quelconque des revendications 1 à 8.

0070746

Office européen des brevets

# RAPPORT DE RECHERCHE EUROPEENNE

Numéro de la demande

EP 82 40 0993

## DOCUMENTS CONSIDERES COMME PERTINENTS

| Categorie | Citation du document avec indication, en cas de besoin, des parties pertinentes | Revendication concernee | CLASSEMENT DE LA DEMANDE (Int. Cl. 3) |
|---|---|---|---|
| A | EP-A-0 016 663 (RHONE-POULENC) *Revendications 1,4* | 1 | C 09 D 3/82<br>C 08 L 83/06<br>C 08 L 83/08<br>G 03 F 7/10 |
| P,A | GB-A-2 066 833 (GENERAL ELECTRIC) *Revendication 1* | 1 | |
| A | DE-A-2 736 499 (WACKER) *Revendication* | | |

| DOMAINES TECHNIQUES RECHERCHES (Int. Cl. 3) |
|---|
| C 09 D<br>C 08 L |

Le present rapport de recherche a eté etabli pour toutes les revendications

| Lieu de la recherche | Date d'achèvement de la recherche | Examinateur |
|---|---|---|
| LA HAYE | 27-09-1982 | DEPIJPER R.D.C. |

CATEGORIE DES DOCUMENTS CITES

X : particulièrement pertinent à lui seul
Y : particulièrement pertinent en combinaison avec un autre document de la même categorie
A : arrière-plan technologique
O : divulgation non-ecrite
P : document intercalaire
T : théorie ou principe à la base de l'invention
E : document de brevet anterieur, mais publié à la date de depôt ou après cette date
D : cité dans la demande
L : cité pour d'autres raisons

& : membre de la même famille, document correspondant

OEB Form 1503 03 82